# EUROPEAN PATENT APPLICATION

(11) **EP 4 394 890 A1**
(43) Date of publication of application: **03.07.2024**
(21) Application number: 21957058.7
(22) Date of filing: 15.09.2021
(51) Int. Cl.: H01L 29/778, H01L 21/335

(54) **SEMICONDUCTOR DEVICE AND PREPARATION METHOD THEREFOR, AND POWER AMPLIFICATION CIRCUIT AND ELECTRONIC DEVICE**

(71) Applicant: Huawei Technologies Co., Ltd., Shenzhen, Guangdong 518129 (CN)
(72) Inventor: ZHANG, Zhili, Shenzhen, Guangdong 518129 (CN); RAO, Jin, Shenzhen, Guangdong 518129 (CN); LIU, Tao, Shenzhen, Guangdong 518129 (CN); LI, Haijun, Shenzhen, Guangdong 518129 (CN); LI, Shuiming, Shenzhen, Guangdong 518129 (CN); LU, Ming, Shenzhen, Guangdong 518129 (CN)
(74) Representative: Isarpatent
(86) International application number: PCT/CN2021/118619
(87) International publication number: WO 2023/039768

(57) **Abstract**

Embodiments of this application provide a semiconductor device and a manufacturing method therefor, a power amplification circuit, and an electronic device, and relate to the field of semiconductor technologies, to reduce impact on the semiconductor device caused by disposing a backside via. The semiconductor device includes: a substrate; a channel layer and a barrier layer, sequentially disposed on the substrate in a stacked manner; a source, a gate, and a drain, disposed on the barrier layer; a backside via, running through a region from the substrate to the barrier layer below the source; and a backside conductive layer, covering the backside via and a back surface of the substrate, where the source is in contact with and connected to the backside conductive layer.

## Description

### TECHNICAL FIELD

This application relates to the field of semiconductor technologies, and in particular, to a semiconductor device and a manufacturing method therefor, a power amplification circuit, and an electronic device.

### BACKGROUND

With development of semiconductor technologies, a semiconductor device with a high thermal conductivity, a high electron drift velocity, high-temperature resistance, and a stable chemical property is widely used in high-frequency, high-temperature, and microwave fields.

For example, when the semiconductor device is used in an integrated circuit such as a power amplification circuit, a source of the semiconductor device needs to be grounded. A backside via structure is usually used to reduce a parasitic capacitance and an inductance of the semiconductor device. The source of the semiconductor device is connected to a back surface of the semiconductor through a backside via, so that the source of the semiconductor device is directly grounded.

However, in the current technology, when a source in a high-power device needs to be grounded, a backside via is disposed below the source. In this way, a size of the source is increased, so that a size and performance of the semiconductor device are affected. Therefore, how to reduce impact of the backside via on the semiconductor device becomes a technical problem that needs to be resolved currently by a person skilled in the art.

### SUMMARY

Embodiments of this application provide a semiconductor device and a manufacturing method therefor, a power amplification circuit, and an electronic device, to reduce impact on the semiconductor device caused by disposing a backside via.

To achieve the foregoing objective, the following technical solutions are used in this application.

According to a first aspect of embodiments of this application, a semiconductor device is provided, including: a substrate; a channel layer and a barrier layer, sequentially disposed on the substrate in a stacked manner; a source, a gate, and a drain, disposed on the barrier layer; a backside via, running through a region from the substrate to the barrier layer below the source; and a backside conductive layer, covering the backside via and a back surface of the substrate, where the source is in contact with and connected to the backside conductive layer.

In this embodiment of this application, the source is directly in ohmic contact with the barrier layer, and the backside via is located below the source. In this way, the backside via is disposed below the source, and the backside conductive layer is directly in contact with and connected to the source through the backside via. A signal is directly conducted from the source to the backside conductive layer, so that a transmission path to the source is shortened. This can reduce an inductance of the semiconductor device, and increase a frequency of the semiconductor device. In addition, a width of the backside via may be set properly as required, and the width of the backside via does not need to be additionally reduced, to reduce manufacturing process difficulty and a yield rate of the backside via, and improve a yield rate and reliability of the backside conductive layer, so that a yield rate and reliability of the semiconductor device are improved. Therefore, a size of the device source is reduced, so that a small-sized and low-cost semiconductor device can be obtained through manufacturing.

In some embodiments, a work function of a material of the source is within a range of 4.3 eV to 6 eV. The material of the source is selected as a metal (for example, titanium, gold, and platinum) with a high work function and a stable chemical property or an alloy including an element, and no longer includes a reactive metal such as aluminum. In a process of manufacturing the semiconductor device, the source is enabled to block etching of the backside via, and corrosion in backside via process wet processing can be avoided. As a result, even if the source is touched during the backside via process, no damage is caused to the source. Therefore, the source does not need to avoid the backside via, to obtain through manufacturing the above semiconductor device. The manufacturing process is simple, and there is no need to increase the processing difficulty. This is easy to implement.

In some embodiments, the material of the source includes at least one of elements titanium, gold, and platinum. There are several common metal elements.

In some embodiments, the source includes at least one conductive layer. In a case in which the source includes one conductive layer, a structure is simple and the manufacturing process is simple. In a case in which the source includes a plurality of conductive layers, characteristics of different materials may be fused together, so that a stress and resistivity of the source are adjustable. The source may further be enabled to include a conductive layer that functions to block, to block diffusion between a plurality of layers of metal. This avoids damage to the semiconductor device caused by volume expansion of the source.

In some embodiments, the source includes a first conductive layer and a second conductive layer that are sequentially stacked. The first conductive layer includes a titanium element, the second conductive layer includes a gold element, and the first conductive layer is in contact with and connected to the barrier layer. The titanium element is disposed on a surface of a stacked semiconductor layer (for example, the barrier layer). A conductive function is performed while an adhesive function may be further performed. This improves effect of a connection of the source and the drain to the stacked semiconductor layer.

In some embodiments, a thickness of each conductive layer is within a range of 1 nm to 10000 nm. The thickness of each conductive layer is properly set, so that resistances of the source and the drain can be reduced without a need to dispose an auxiliary electrode. A structure is simple, process steps are few, and manufacturing efficiency is high.

In some embodiments, the source is of a planar structure. The source is of the planar structure, so that a structure is simple and the manufacturing process is simple. In addition, there is no need to consider a problem of how a plurality of strip structures are interconnected after an opening is disposed on the source and the source is divided into structures including a plurality of strip patterns.

In some embodiments, the source has an opening, and the opening is located above the backside via. In this embodiment of this application, the source is not corroded due to etching in a backside via manufacturing process. In other words, even if the source is touched in the backside via process, the source is not damaged. Therefore, there is no need to set the opening on the source to be larger than a size of the backside via to avoid corrosion caused by the process of the backside via. This reduces the size of the source and reduces a size of the entire semiconductor device.

In some embodiments, the semiconductor device further includes a thickened source, and the thickened source is disposed on a surface of the source. The thickened source is disposed, and it is equivalent to increasing the thickness of the source and reducing the resistance of the source, so that a current conduction capability of the semiconductor device is improved.

In some embodiments, the semiconductor device further includes a thickened source, the thickened source is disposed on a surface of the source, and the thickened source is in contact with the backside conductive layer through the opening.

In some embodiments, the semiconductor device further includes a thickened drain, and the thickened drain is disposed on a surface of the drain. The thickened drain is disposed, and it is equivalent to increasing the thickness of the drain and reducing the resistance of the drain, so that a current conduction capability of the semiconductor device is improved.

In some embodiments, the semiconductor device further includes a field plate. The field plate is disposed on a side that is of the gate and that is away from the substrate, is located between the gate and the drain, and overlaps a projection of the gate. An electric field peak is likely to occur at a position of the gate. Therefore, the field plate is disposed above the gate, so that electric field distribution in the semiconductor device may be modulated. This enables the electric field distribution to be even, and the electric field peak is avoided.

According to a second aspect, a power amplification circuit is provided, including a package structure and the semiconductor device according to any one of the first aspect. The semiconductor device is packaged inside the package structure.

The power amplification circuit provided in this embodiment of this application includes the semiconductor device in the first aspect. Beneficial effects of the power amplification circuit are the same as beneficial effects of the semiconductor device. Details are not described herein again.

According to a third aspect, an electronic device is provided, including a power amplifier and an antenna. The power amplifier is configured to amplify a radio frequency signal and output the amplified radio frequency signal to the antenna for external radiation, and the power amplifier includes the power amplification circuit according to the second aspect.

The electronic device provided in this embodiment of this application includes the semiconductor device in the first aspect. Beneficial effects of the electronic device are the same as beneficial effects of the semiconductor device. Details are not described herein again.

According to a fourth aspect, a manufacturing method for a semiconductor device is provided, including: sequentially forming, on a substrate, a channel layer and a barrier layer that are disposed in a stacked manner; forming a source, a gate, and a drain on the barrier layer; forming a backside via below the source, where the backside via runs through a region from the substrate to the barrier layer below the source; and forming a backside conductive layer on a back surface of the substrate, where the backside conductive layer covers the backside via and the back surface of the substrate, and the source is in contact with and connected to the backside conductive layer.

According to the manufacturing method for the semiconductor device provided in this embodiment of this application, when the source is formed, a material of the source is selected as a metal (for example, titanium, gold, and platinum) with a high work function and a stable chemical property, and no longer includes a reactive metal. A manufacturing process or the material of the source is adjusted, so that the source directly forms an ohmic contact with the barrier layer. In a process of manufacturing a semiconductor device, the source is enabled to block etching of the backside via, and corrosion in backside via process wet processing can be avoided. In this way, the finally formed backside via is disposed below the source, and the backside conductive layer is directly in contact with and connected to the source through the backside via. A signal is directly conducted from the source to the backside conductive layer, so that a transmission path to the source is shortened. This can reduce an inductance of the semiconductor device, and increase a frequency of the semiconductor device. In addition, a width of the backside via may be set properly as required, and the width of the backside via does not need to be additionally reduced, to reduce manufacturing process difficulty and a yield rate of the backside via, and improve a yield rate and reliability of the backside conductive layer, so that a yield rate and reliability of the semiconductor device are improved. Therefore, a size of the device source is reduced, so that a small-sized and low-cost semiconductor device can be obtained through manufacturing.

In some embodiments, the forming a backside via below the source includes: making, from the back surface of the substrate, a via on a film layer below the source by using a dry etching process, to form the backside via; and removing an etching by-product that remains in the via through dry etching or wet etching.

### BRIEF DESCRIPTION OF DRAWINGS

FIG. 1A is a schematic diagram of a framework of a terminal according to an embodiment of this application;
FIG. 1B is a schematic diagram of a framework of a base station according to an embodiment of this application;
FIG. 1C is a schematic diagram of a framework of a power amplification circuit according to an embodiment of this application;
FIG. 2A is a schematic top view of an integrated circuit according to an embodiment of this application;
FIG. 2B is a schematic top view of another integrated circuit according to an embodiment of this application;
FIG. 2C is a sectional view along a direction A1-A2 of FIG. 2B;
FIG. 3A is a schematic top view of still another integrated circuit according to an embodiment of this application;
FIG. 3B is a sectional view along a direction B1-B2 of FIG. 3A;
FIG. 4 is a flowchart of manufacturing a semiconductor device according to an embodiment of this application;
FIG. 5A to FIG. 5G are schematic diagrams of a manufacturing process of a semiconductor device according to an embodiment of this application;
FIG. 6A is a schematic diagram of a structure of a semiconductor device according to an embodiment of this application;
FIG. 6B is a schematic diagram of a structure of another semiconductor device according to an embodiment of this application;
FIG. 6C is a schematic diagram of a structure of still another semiconductor device according to an embodiment of this application;
FIG. 7A is a schematic top view of yet another integrated circuit according to an embodiment of this application;
FIG. 7B is a schematic top view of still yet another integrated circuit according to an embodiment of this application;
FIG. 7C is a sectional view along a direction C 1-C2 of FIG. 7B;
FIG. 8 is a schematic diagram of a structure of yet another semiconductor device according to an embodiment of this application;
FIG. 9A is a schematic diagram of a structure of still yet another semiconductor device according to an embodiment of this application;
FIG. 9B is a schematic diagram of a structure of a further semiconductor device according to an embodiment of this application;
FIG. 9C is a schematic diagram of a structure of a still further semiconductor device according to an embodiment of this application;
FIG. 10A is a schematic diagram of a structure of a yet further semiconductor device according to an embodiment of this application;
FIG. 10B is a schematic diagram of a structure of a still yet further semiconductor device according to an embodiment of this application;
FIG. 10C is a schematic diagram of a structure of even yet another semiconductor device according to an embodiment of this application; and
FIG. 11 is a schematic diagram of a structure of even still another semiconductor device according to an embodiment of this application.

### DESCRIPTION OF EMBODIMENTS

The following describes the technical solutions in embodiments of this application with reference to the accompanying drawings in embodiments of this application. It is clearly that the described embodiments are merely some rather than all of embodiments of this application.

The following describes technical terms used in embodiments of this application.

Semiconductor: A semiconductor is a material whose conductivity is between a conductor and an insulator at a normal temperature. The semiconductor includes an intrinsic semiconductor and an extrinsic semiconductor. A pure semiconductor without impurities and defects and with the same concentration of electrons and holes inside, is called the intrinsic semiconductor. A semiconductor that is doped with a specific quantity of impurities is called the extrinsic semiconductor or a non-intrinsic semiconductor. The impurities doped into the extrinsic semiconductor can provide a carrier (for example, a hole or an electron) of a specific concentration. The extrinsic semiconductor doped with the impurity (for example, a 5-valent phosphorus element) that provides the electron is also referred to as an electronic semiconductor or an N (negative, negative) semiconductor. The extrinsic semiconductor doped with the impurity (for example, a 3-valent boron element) that provides the hole is also referred to as a hole semiconductor or a P (positive, positive) semiconductor. Doping can improve a conductivity of the intrinsic semiconductor. Generally, as the carrier concentration gets higher, a resistivity of the semiconductor becomes lower and the conductivity becomes better. In embodiments of this application, a layer structure in a device manufactured by using the semiconductor (or a semiconductor material) is referred to as a semiconductor layer.

Hereinafter, the terms "first", "second", and the like in embodiments of this application are merely intended for ease of description, and shall not be understood as an indication or implication of relative importance or implicit indication of a quantity of indicated technical features. Therefore, a feature limited by "first", "second", or the like may explicitly or implicitly include one or more features. In description of this application, unless otherwise stated, "a plurality of" means two or more than two.

In embodiments of this application, "up", "down", "left", and "right" are not limited to being defined relative to placement orientations of components shown in the accompanying drawings. It should be understood that these directional terms may be relative concepts and are used for relative description and clarification, and may vary correspondingly based on changes of the placement orientations of the components in the accompanying drawings.

In embodiments of this application, unless otherwise required by the context, throughout the entire specification and claims, the term "include" is interpreted as "open and inclusive", that is, "include, but not limited to". In descriptions of this specification, the terms such as "one embodiment", "some embodiments", "an example embodiment ", "for example", "some examples" or the like are intended to indicate that a specific feature, structure, material, or characteristic related to this embodiment or example is included in at least one embodiment or example of the present disclosure. The schematic representations of the foregoing terms do not necessarily mean a same embodiment or example. Moreover, the specific feature, structure, material, or characteristic may be included in any one or more embodiments or examples in any appropriate manner.

When some embodiments are described, expressions of "electrically connected" and "connected" and their extensions may be used. For example, when some embodiments are described, the term "connected" may be used to indicate that two or more components are in direct physical contact or electrical contact with each other. For another example, when some embodiments are described, the term "electrically connected" may be used to indicate that two or more components are in direct physical contact or electrical contact with each other. However, the term "electrically connected" may also indicate that two or more components are not in direct contact with each other, but still cooperate or interact with each other. Embodiments disclosed herein are not necessarily limited to the content of this specification.

In embodiments of this application, "and/or" describes only an association relationship for describing associated objects and represents that three relationships may exist. For example, A and/or B may represent the following three cases: only A exists, both A and B exist, and only B exists. In addition, the character "/" in this specification usually indicates an "or" relationship between associated objects.

Unless otherwise defined, all scientific and technical terms used in this specification have same meaning as those commonly understood by a person of ordinary skill in the art. In this application, "at least one (layer)" means one (layer) or more (layers), and "a plurality of (layers)" means two (layers) or more (layers). "At least one of the following items" or a similar expression thereof means any combination of these items, including a singular item or any combination of plural items. For example, at least one of a, b, or c may represent: a, b, c, a and b, a and c, b and c, or a, b, and c, where a, b, and c may be singular or plural.

In embodiments of this application, an example implementation is described with reference to a sectional view and/or a plan view and/or an equivalent circuit diagram that are/is used as an idealized example accompanying drawing. In the accompanying drawings, for clarity, thicknesses of a layer and a region are enlarged. Thus, a change in a shape relative to the accompanying drawings caused due to factors such as manufacturing techniques and/or tolerances may be conceived. Therefore, an example implementation should not be construed as being limited to a shape of the region shown in this specification, but rather include a shape deviation caused by factors such as manufacturing. For example, an etching region shown as a rectangle typically has a bending characteristic. Therefore, regions shown in the accompanying drawings are essentially examples, and their shapes are not intended to show actual shapes of the regions of the device, and are not intended to limit the scope of the example implementations.

An embodiment of this application provides an electronic device. The electronic device may be different types of user equipment or terminal devices such as a lidar driver, a laser, a detector, a radar, and a 5G (the 5th generation mobile network, fifth generation mobile communication technology) communication device. The electronic device may alternatively be a network device such as a base station. Alternatively, the electronic device may be an apparatus such as a power amplifier used in the foregoing electronic device. A specific form of the foregoing electronic device is not specially limited in embodiments of this application.

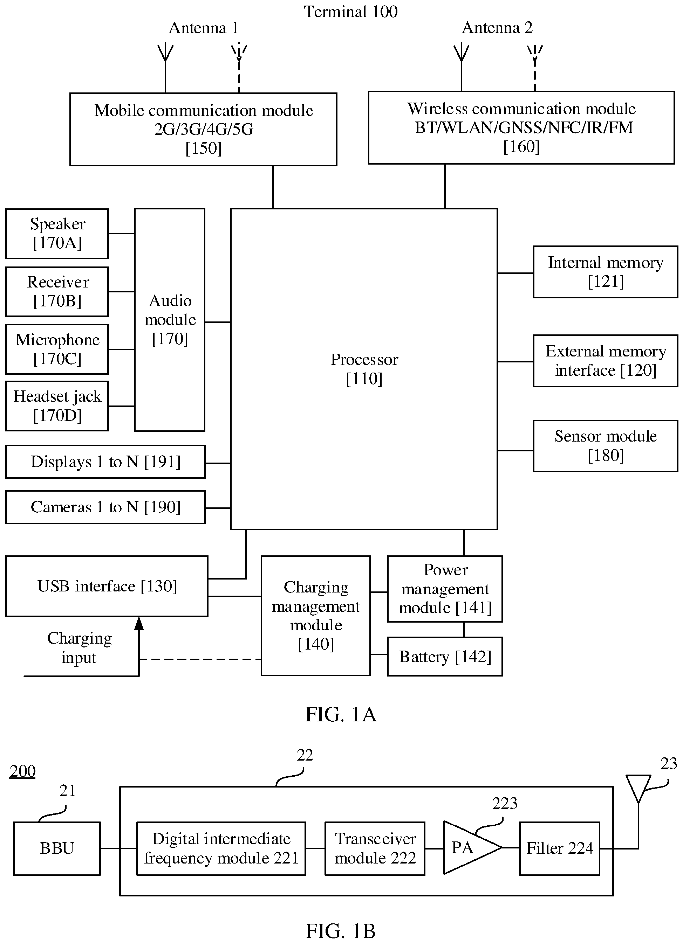

For example, the electronic device provided in this embodiment of this application is a mobile phone. FIG. 1A is a schematic diagram of a structure of a mobile phone 100. The mobile phone 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a camera 190, a display 191, and the like.

It may be understood that the structure shown in this embodiment of this application does not constitute a specific limitation on the mobile phone 100. In some other embodiments of this application, the mobile phone 100 may include more or fewer components than those shown in the figure, some components may be combined, some components may be split, or different component arrangements may be used. The components shown in the figure may be implemented in hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent components, or may be integrated into one or more processors.

A memory may be further disposed in the processor 110, and is configured to store instructions and data. In some embodiments, the memory in the processor 110 is a cache. The memory may store instructions or data that has been used or cyclically used by the processor 110. If the processor 110 needs to use the instructions or the data again, the instructions or the data may be directly invoked from the memory. This avoids repeated access, reduces waiting time of the processor 110, and improves system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

The charging management module 140 is configured to receive a charging input from a charger. The charger may be a wireless charger or a wired charger. In some embodiments of wired charging, the charging management module 140 may receive a charging input from the wired charger through the USB interface 130. In some embodiments of wireless charging, the charging management module 140 may receive a wireless charging input through a wireless charging coil of the mobile phone 100. The charging management module 140 supplies power to the mobile phone by using the power management module 141 while charging the battery 142.

The power management module 141 is configured to connect to the battery 142, the charging management module 140, and the processor 110. The power management module 141 receives an input from the battery 142 and/or the charging management module 140, and supplies power to the processor 110, the internal memory 121, the display 191, the camera 190, the wireless communication module 160, and the like. The power management module 141 may be further configured to monitor parameters such as a battery capacity, a battery cycle count, and a battery health status (electric leakage or impedance). In some other embodiments, the power management module 141 may alternatively be disposed in the processor 110. In some other embodiments, the power management module 141 and the charging management module 140 may alternatively be disposed in a same device.

A wireless communication function of the mobile phone 100 may be implemented through the antenna 1, the antenna 2, the mobile communication module 150, the wireless communication module 160, the modem processor, the baseband processor, and the like.

The antenna 1 and the antenna 2 are configured to transmit and receive electromagnetic wave signals. Each antenna in the mobile phone 100 may be configured to cover one or more communication bands. Different antennas may be further multiplexed, to improve antenna utilization. For example, the antenna 1 may be multiplexed as a diversity antenna of a wireless local area network. In some other embodiments, the antenna may be used in combination with a tuning switch.

The mobile communication module 150 may provide a wireless communication solution that is applied to the mobile phone 100, including 2G, 3G, 4G, 5G, and the like. The mobile communication module 150 may include one or more filters, a switch, a power amplifier, a low noise amplifier (low noise amplifier, LNA), and the like. The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules in the mobile communication module 150 may be disposed in the processor 110. In some embodiments, at least some functional modules of the mobile communication module 150 may be disposed in a same device as at least some modules of the processor 110.

The modem processor may include a modulator and a demodulator. The modulator is configured to modulate a to-be-sent low-frequency baseband signal into a medium-high frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal by using an audio device (which is not limited to the speaker 170A, the receiver 170B, or the like), or displays an image or a video through the display 191. In some embodiments, the modem processor may be an independent component. In some other embodiments, the modem processor may be independent of the processor 110, and is disposed in a same device as the mobile communication module 150 or another functional module.

The wireless communication module 160 may provide the wireless communication solution that is applied to the mobile phone 100, for example, a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, and an infrared (infrared, IR) technology. The wireless communication module 160 may be one or more devices integrating one or more communication processing modules. The wireless communication module 160 receives an electromagnetic wave through the antenna 2, performs frequency modulation and filtering processing on the electromagnetic wave signal, and sends a processed signal to the processor 110. The wireless communication module 160 may further receive a to-be-sent signal from the processor 110, perform frequency modulation and amplification on the signal, and convert the signal into an electromagnetic wave for radiation through the antenna 2.

In some embodiments, in the mobile phone 100, the antenna 1 and the mobile communication module 150 are coupled, and the antenna 2 and the wireless communication module 160 are coupled, so that the mobile phone 100 can communicate with a network and another device by using a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, a GNSS, a WLAN, NFC, FM, an IR technology, and/or the like. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or satellite based augmentation systems (satellite based augmentation system, SBAS).

The mobile phone 100 implements a display function by using the GPU, the display 191, the application processor, and the like. The GPU is a microprocessor for image processing, and is connected to the display 191 and the application processor. The GPU is configured to: perform mathematical and geometric computation, and render an image. The processor 110 may include one or more GPUs that execute program instructions to generate or change display information.

The display 191 is configured to display an image, a video, and the like. The display 191 includes a display panel. The display panel may be a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flex light-emitting diode, FLED), a mini-LED, a micro-LED, a micro-OLED, a quantum dot light-emitting diode (quantum dot light-emitting diode, QLED), or the like. In some embodiments, the mobile phone 100 may include one or N displays 191, where N is a positive integer greater than 1. The mobile phone 100 may implement a photographing function by using the ISP, the camera 190, the video codec, the GPU, the display 191, the application processor, and the like.

The ISP may be configured to process data fed back by the camera 190. For example, during photographing, a shutter is pressed, and light is transmitted to a photosensitive element of the camera through a lens. An optical signal is converted into an electrical signal, and the photosensitive element of the camera transmits the electrical signal to the ISP for processing, to convert the electrical signal into a visible image. The ISP may further perform algorithm optimization on noise, brightness, and complexion of the image. The ISP may further optimize parameters such as exposure and a color temperature of a photographing scenario. In some embodiments, the ISP may be disposed in the camera 190.

The camera 190 is configured to capture a still image or a video. An optical image of an object is generated through the lens, and is projected onto the photosensitive element. The photosensitive element may be a charge coupled device (charge coupled device, CCD), or a complementary metal-oxide-semiconductor (complementary metal-oxide-semiconductor, CMOS) phototransistor. The light-sensitive element converts an optical signal into an electrical signal, and then transmits the electrical signal to the ISP to convert the electrical signal into a digital image signal. The ISP outputs the digital image signal to the DSP for processing. The DSP converts the digital image signal into an image signal in a standard format such as RGB or YUV. In some embodiments, the mobile phone 100 may include one or N cameras 190, where N is a positive integer greater than 1.

The external memory interface 120 may be configured to connect to an external memory card, for example, a micro SD card, to extend a storage capability of the mobile phone 100. The external memory card communicates with the processor 110 through the external memory interface 120, to implement a data storage function. For example, files such as music and videos are stored in the external storage card.

The internal memory 121 may be configured to store one or more computer programs, and the one or more computer programs include instructions. The processor 110 may run the instructions stored in the internal memory 121, to enable the mobile phone 100 to perform various function applications, data processing, and the like. The internal memory 121 may include a program storage region and a data storage region. The program storage region may store an operating system. The program storage region may further store one or more applications (such as Gallery or Contacts), and the like. The data storage region may store data (for example, a photo and a contact) created during use of the mobile phone 100, and the like. In addition, the internal memory 121 may include a high-speed random access memory, and may further include a non-volatile memory, such as one or more disk storage components, a flash storage device, or a universal flash storage (universal flash storage, UFS). In some other embodiments, the processor 110 runs the instructions stored in the internal memory 121 and/or the instructions stored in the memory that is disposed in the processor, to enable the mobile phone 100 to perform various function applications and data processing.

The mobile phone 100 may implement an audio function, for example, music playing and recording, through the audio module 170, the speaker 170A, the receiver 170B, the microphone 170C, the headset jack 170D, the application processor, and the like.

The audio module 170 is configured to convert digital audio information into an analog audio signal output, and is further configured to convert an analog audio input into a digital audio signal. The audio module 170 may be further configured to encode and decode an audio signal. In some embodiments, the audio module 170 may be disposed in the processor 110, or some functional modules in the audio module 170 are disposed in the processor 110.

The speaker 170A, also referred to as a "loudspeaker", is configured to convert an audio electrical signal into a sound signal. The mobile phone 100 may use the speaker 170A to play music or receive a hand-free call.

The receiver 170B, also referred to as an "earpiece", is configured to convert an audio electrical signal into a sound signal. When the mobile phone 100 receives a call or a voice message, the receiver 170B may be placed close to a human ear for the voice to be heard.

The microphone 170C, also referred to as a "mike" or a "mic", is configured to convert a sound signal into an electrical signal. When making a call or sending a voice message, a user may make a sound by moving a human mouth close to the microphone 170C to input a sound signal to the microphone 170C. One or more microphones 170C may be disposed in the mobile phone 100. In some other embodiments, two microphones 170C may be disposed in the mobile phone 100, to collect a sound signal and further implement a noise reduction function. In some other embodiments, three, four, or more microphones 170C may alternatively be disposed in the mobile phone 100, to collect a sound signal, reduce noise, further identify a sound source, implement a directional recording function, and the like.

The headset jack 170D is configured to connect to a wired headset. The headset jack 170D may be a USB interface 130, or may be a 3.5 mm open mobile terminal platform (open mobile terminal platform, OMTP) standard interface or cellular telecommunications industry association of the USA (cellular telecommunications industry association of the USA, CTIA) standard interface.

The sensor module 180 may include a pressure sensor, a gyroscope sensor, a barometric pressure sensor, a magnetic sensor, an acceleration sensor, a distance sensor, an optical proximity sensor, a fingerprint sensor, a temperature sensor, a touch sensor, an ambient light sensor, a bone conduction sensor, and the like.

In embodiments of this application, the touch sensor is also referred to as a "touch control component". The touch sensor may be disposed in the display 191, so that the touch sensor and the display 191 constitute a touchscreen, also referred to as a "touch screen". The touch sensor is configured to detect a touch operation performed on or near the touch sensor. The touch sensor may transfer the detected touch operation to the application processor to determine a type of the touch event. A visual output related to the touch operation may be provided by using the display. In some other embodiments, a touch panel of a touch sensor array formed by a plurality of touch sensors may alternatively be disposed on a surface of the display panel in an external attachment form. In some other embodiments, the touch sensor may alternatively be located at a position different from that of the display 191. A form of the touch sensor is not limited in this embodiment of this application. For example, the touch sensor may be a component such as a capacitor or a varistor.

In addition, the mobile phone 100 may further include one or more components such as a button, a motor, an indicator, and a subscriber identity module (subscriber identity module, SIM) card interface. This is not limited in embodiments of this application.

For example, the electronic device provided in this embodiment of this application is a 5G base station. The 5G base station may be divided into different architectures such as a baseband processing unit (base band unit, BBU), an active antenna unit (active antenna unit, AAU), a central unit-distribute unit (central unit-distribute unit, CU-DU), an AAU, a BBU, a remote radio unit (remote radio unit, RRU), an antenna (antenna), a CU-DU-RRU-Antenna, and an integrated 5G node base station (5G node base station, gNB).

FIG. 1B shows an example of a base station 200 of a BBU-RRU architecture. The base station 200 may include a BBU 21, an RRU 22, and an antenna 23. The BBU 21 and the RRU 22 are connected through an optical fiber, and an interface between the BBU 21 and the RRU 22 is based on a common public radio interface (common public radio interface, CPRI) and an open base station architecture initiative (open base station architecture initiative, OBSAI). The BBU 21 processes a generated baseband signal by using the RRU 22, and then sends the processed baseband signal to the antenna 23 for transmission. The RRU 22 includes a digital intermediate frequency module 221, a transceiver module 222, a power amplifier 223 (power amplifier, PA), and a filter 224. The digital intermediate frequency module 221 is configured to perform modulation and demodulation, a digital up and down conversion, a digital to analog conversion (digital to analog converter, D/A), and the like of a baseband signal transmitted through the optical fiber to form an intermediate frequency signal. The transceiver module 222 completes a conversion from the intermediate frequency signal to a radio frequency signal. The power amplifier 223 is configured to amplify power of a low-power radio frequency signal. The filter 224 is configured to filter the radio frequency signal, and then transmit the radio frequency signal through the antenna 23.

An embodiment of this application further provides a power amplification circuit. The power amplification circuit may be used in the power amplifier of the mobile communication module 150 or the wireless communication module 160 in the mobile phone 100 shown in FIG. 1A, or may be used in the power amplifier of the RRU 22 in the base station 200 shown in FIG. 1B. Certainly, a specific application scenario is not limited to the mobile phone 100 shown in FIG. 1A and the base station 200 shown in FIG. 1B. It may be understood that any electronic device that needs to amplify a signal by using the power amplification circuit in the power amplifier belongs to an application scenario of embodiments of this application.

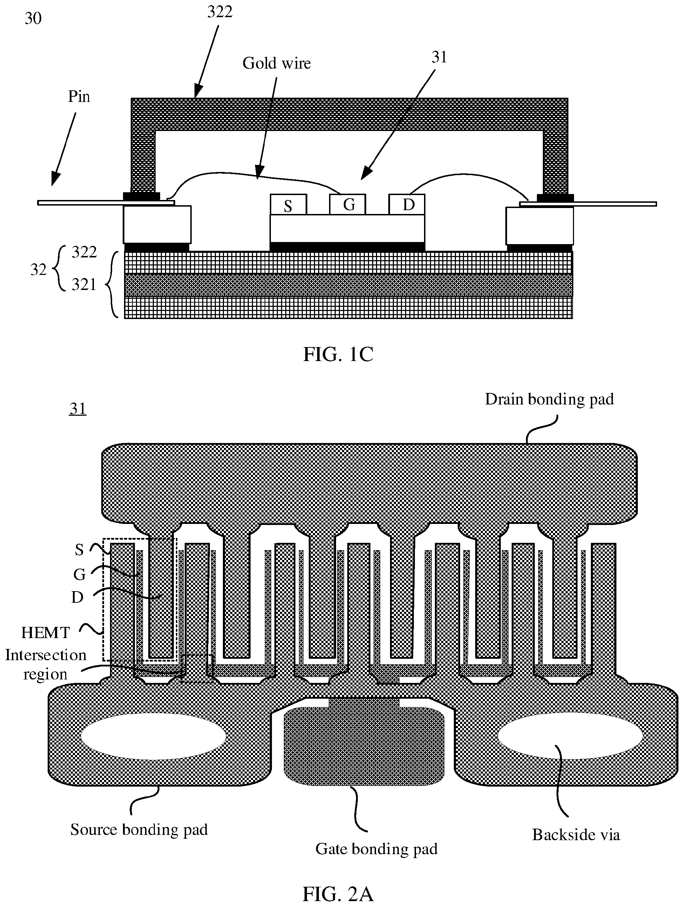

For example, FIG. 1C shows a power amplification circuit 30. The power amplification circuit 30 includes an integrated circuit 31 and a package structure 32. The integrated circuit 31 is packaged inside the package structure 32. As shown in FIG. 1C, a specific package structure of the power amplification circuit 30 is provided. The integrated circuit 31 is packaged in the package structure 32 of the power amplification circuit 30.

As shown in FIG. 1C, the package structure 32 specifically includes a heat dissipation base board 321. To improve conductivity and heat dissipation of the heat dissipation base board 321, the heat dissipation base board 321 may use a composite material, for example, a laminated structure formed by copper Cu/molybdenum Mo/copper Cu. The integrated circuit 31 is bonded to or directly welded to the heat dissipation base board 321 through silver sintering.

The integrated circuit 31 includes at least one transistor. Some electrodes (for example, a source S) of the transistor are conducted with the heat dissipation base board 321, to implement grounding of the source S. Some electrodes (for example, a drain D and a gate G) of the transistor are connected to pins through wire bonding by using a gold wire. The pins are disposed on an insulation layer (for example, an insulation ceramic), and the insulation layer is bonded to the heat dissipation base board 321 by using an insulation adhesive.

In addition, the package structure 32 includes a package housing 322. The package housing 322 is bonded to the heat dissipation base board 321 by using an insulation adhesive, and one end of the pin is exposed from the package structure to connect to another circuit. The integrated circuit 31 is disposed in space surrounded by the package housing 322 and the heat dissipation base board 321.

A high electron mobility transistor (high electron mobility transistor, HEMT) device is a semiconductor device, and is widely used as the transistor in the integrated circuit 31 due to its advantages such as a high breakdown electric field, a high channel electron concentration, high electron mobility, and high-temperature stability. An example in which the semiconductor device provided in this embodiment of this application is the HEMT device is used below for description.

In some application scenarios (for example, the integrated circuit 31 is a circuit structure in the power amplification circuit), a source of the HEMT device needs to be grounded. A ground cable is led out from the top of the source. Therefore, the ground cable overlaps another lead in the HEMT device, and a parasitic capacitor is generated. In addition, as shown in FIG. 1C, the heat dissipation base board 321 is located on a back surface of the HEMT device. The ground cable is led out to the heat dissipation base board 321, so that a length of the ground cable may be increased and an inductance is increased.

As a result, in some embodiments, a backside via structure is usually used to reduce the parasitic capacitance and the inductance of the HEMT device. The source of the HEMT device is directly connected to the back surface of the HEMT device through a backside via for grounding. In this way, overlapping of source, gate, and drain leads and the length of the ground cable may be reduced, and the parasitic capacitance and the inductance of the HEMT device may be reduced.

In addition, due to a limitation of a factor such as a process, a design of the backside via may cause a width of the source (source, S) to increase, so that an overall size of the HEMT device is affected. Therefore, how to reduce a size of the source in the backside via structure, to reduce impact of the size of the source on the size of the HEMT device becomes a technical problem that needs to be resolved by a person skilled in the art.

Based on a position of the backside via in the HEMT device, the backside via is generally classified into an active region backside via and a passive region backside via. The active region backside via is one or more backside via structures disposed below the source. The passive region backside via is one or more backside vias disposed correspondingly at a position of a passive region after a plurality of sources are connected to be aggregated at one position of the passive region.

In some embodiments, as shown in FIG. 2A, an embodiment of this application provides the integrated circuit 31. The integrated circuit 31 includes a plurality of HEMT devices. The backside via in the HEMT device is located outside the source S, and the backside via is located below a source bonding pad. The backside via is manufactured in the passive region to lead the source S of the HEMT device to the back surface for grounding.

In the structure shown in FIG. 2A, because the backside via does not need to be located below a source S in an active region, a size of the source S may be set as required, and an area of the source S does not need to be increased due to existence of the backside via, so that a size of the HEMT device can be reduced.

However, as shown in FIG. 2A, a structure of the backside via is disposed in the passive region, and sources S in the plurality of HEMT devices need to be electrically connected to the source bonding pad. Therefore, in a region where the source S intersects the gate (gate, G), the source S needs to cross the intersection area through a dielectric bridge (a dielectric layer is disposed in the region where the source S intersects the gate G, and sources S on two sides of the gate G are electrically connected through a cross-bridge on the dielectric layer) or an air bridge (the source S jumps in the region where the source S intersects the gate G, and a gap is reserved between the source S and the gate G), to be electrically connected to the source bonding pad.

As a result, the air bridge or the dielectric bridge needs to be manufactured in the HEMT device, and a process is complex. A structure of the air bridge is unstable, and a passivation layer is likely to be cracked in a subsequent process. In addition, the source S intersects the gate G, so that a large parasitic capacitance may be caused. Moreover, because the backside via is disposed below the source bonding pad, a path for transmitting a signal from the source bonding pad to the source S is long. This increases an inductance of the HEMT device and affects a frequency characteristic of the HEMT device.

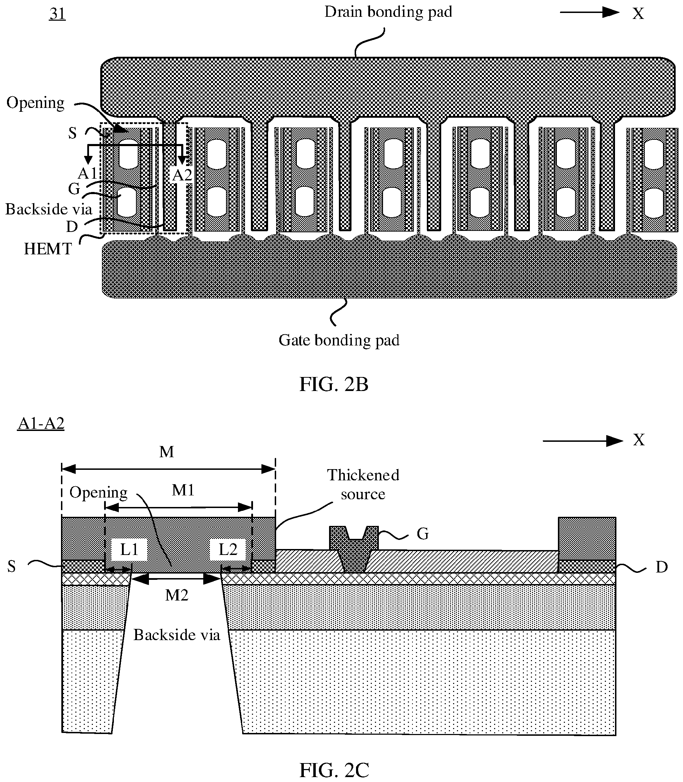

Based on this, to reduce the inductance of the HEMT device, in some embodiments, as shown in FIG. 2B, an embodiment of this application provides the integrated circuit 31. The integrated circuit 31 includes the plurality of HEMT devices. The backside via in the HEMT device is located below the source S. The backside via is manufactured in the active region to lead the source S of the HEMT device to the back surface for grounding.

The backside via is located below the source S, so that the path for transmitting a signal to the source S may be reduced, and the inductance of the HEMT device may be reduced.

However, a material of the source S usually includes a reactive metal, for example, an element such as aluminum. Therefore, there are two main process problems in a manufacturing process of the HEMT device. First, in a process of forming the backside via through etching on the back surface, the source S cannot block etching of the backside via, and the backside via etching cannot stay on a lower surface of the source S. Second, wet etching in a backside via process will cause a metal of the source S to be corroded. Therefore, as shown in FIG. 2C (a sectional view along a direction A1-A2 in FIG. 2B), an opening may be disposed on the source S, and a direction from the source S to the drain D is defined as a width direction (a first direction X). It needs to be ensured that a width M1 of the opening is greater than a width M2 of the backside via, to avoid the source S being touched in the backside via process, so that damage to the source S by the backside via process is avoided. That is, a contour of the opening surrounds a contour of the backside via, and there is a gap L between the contour of the opening and the contour of the backside via. Gaps L (for example, the gaps L1 and L2 on the left and right sides in FIG. 2C) anywhere may be the same or may be different. To ensure that the source S is not damaged, a value of the gap L is usually in a range of 500 nm to 50000 nm.

A width M of the source S is equal to the width M1 of the opening plus a width of the non-opening. Therefore, an introduction of the gap L may increase the width M1 (M1=M2+L1+L2) of the opening on the source S, so that an area of the HEMT device is increased. In addition, after the opening is formed on the source S, in order to block the etching of the backside via, a thickened source needs to be formed on the source S, and the thickened source does not form an ohmic contact with a barrier layer.

Therefore, to reduce the width M1 of the source S, in some embodiments, the width M2 of the backside via is reduced, so that the width M1 of the opening is reduced. This reduces the size of the source S.

However, reducing the width M2 of the backside via may increase a depth-width ratio of the backside via, and increase process difficulty of forming the backside via. In addition, reducing the width M2 of the backside via may increase difficulty in forming a backside conductive layer that covers a surface of the backside via and is in contact with the source S, and affect a yield rate and reliability of the backside conductive layer, so that a yield rate and reliability of the HEMT device is affected.

Based on this, in some embodiments, another HEMT device structure is provided, to resolve a problem that the size of the source S is large. The following describes a structure of the HEMT device by using several examples.

### Example 1

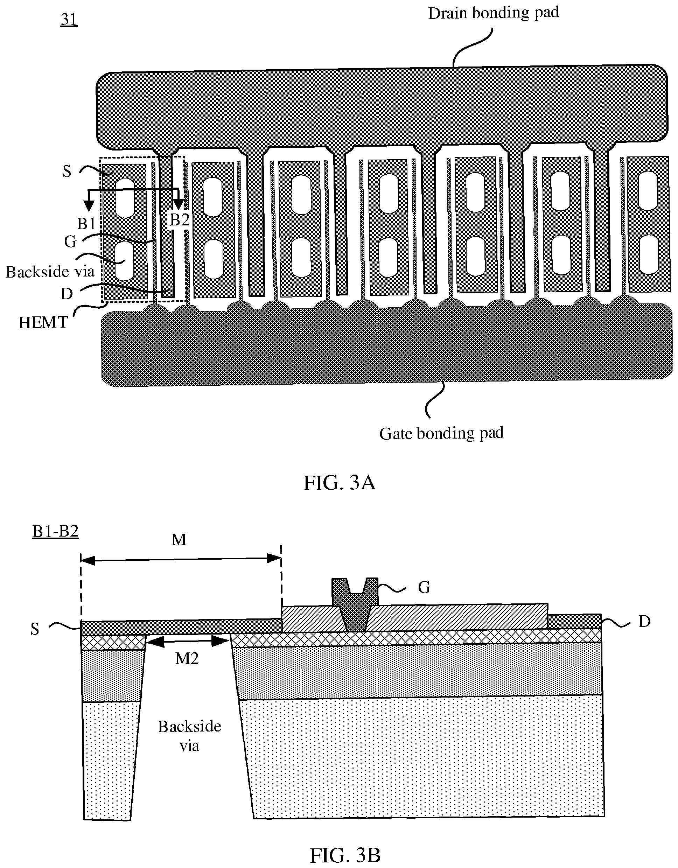

As shown in FIG. 3A, an embodiment of this application provides the integrated circuit 31. The integrated circuit 31 includes the plurality of HEMT devices. The backside via in the HEMT device is located below the source S. The backside via is manufactured in the active region to lead the source S of the HEMT device to the back surface for grounding.

As shown in FIG. 3B (a sectional view along a direction B1-B2 of FIG. 3A), no opening needs to be disposed on the source S.

Because no opening needs to be disposed on the source S, the gaps L1 and L2 in FIG. 2C do not exist. Therefore, the width M2 of the backside via is irrelevant to the width M of the source S. To be specific, increasing the width M2 of the backside via does not necessarily need increasing the width M of the source S, provided that a size of the width M2 of the backside via is smaller than the width M of the source. In this way, the width M2 of the backside via may be designed to be large enough, without necessarily increasing the size of the source S.

The following shows a manufacturing method for the HEMT device shown in FIG. 3B.

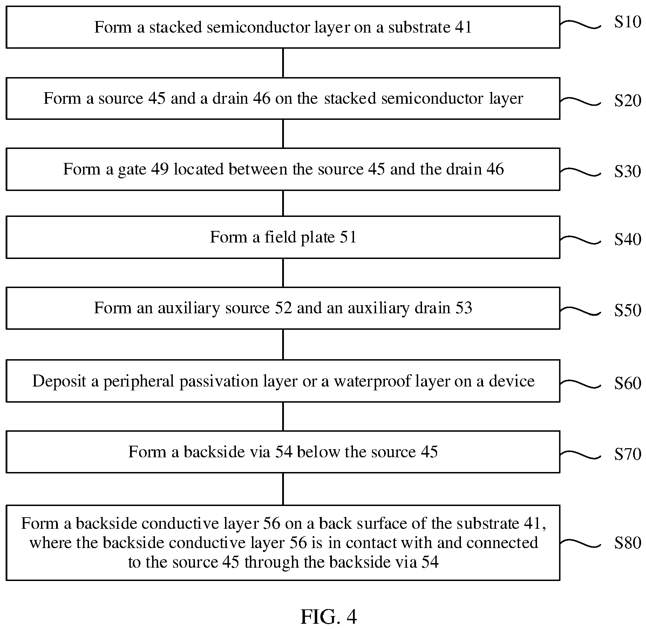

As shown in FIG. 4, the manufacturing method for the HEMT device includes the following steps.

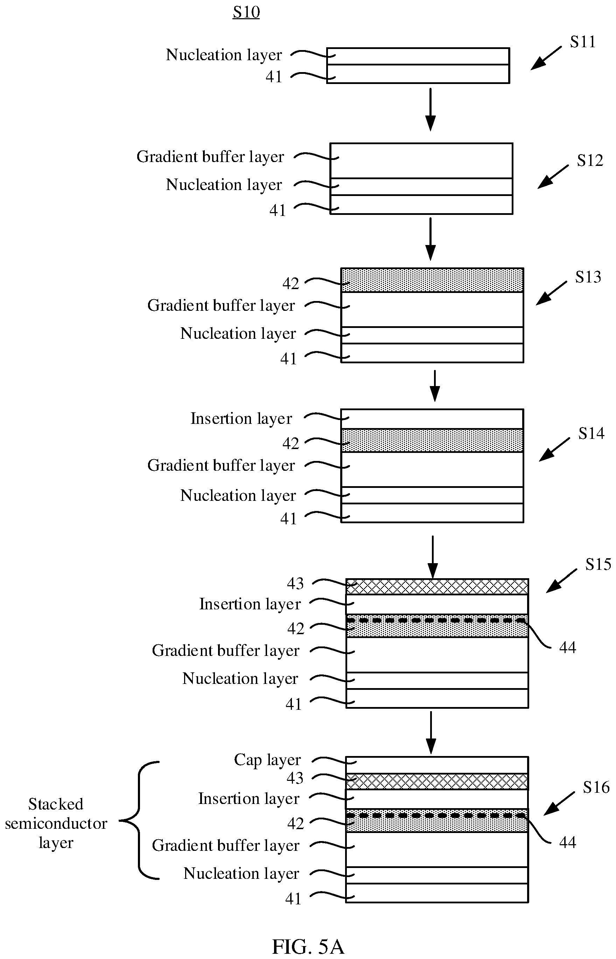

S10: As shown in FIG. 5A, form a stacked semiconductor layer on a substrate 41.

In some embodiments, the stacked semiconductor layer on the substrate 41 includes a nucleation layer, a gradient buffer layer, a channel layer 42, an insertion layer, a barrier layer 43, and a cap layer that are disposed in a stacked manner. The channel layer 42 and the barrier layer 43 form a heterojunction, and two-dimensional electron gas (two-dimensional electron gas, 2DEG) 44 is generated above the channel layer 42.

FIG. 5A shows a method for forming the stacked semiconductor layer, and step S10 includes the following steps.

S 11: Form the nucleation layer on the substrate 41.

The substrate 41 may be, for example, a silicon carbide (SiC) substrate, a silicon (Si) substrate, a sapphire substrate, or a diamond substrate. A material of the substrate 41 is not limited in this embodiment of this application.

The nucleation layer is formed on the substrate 41. In other words, as shown in FIG. 5A, the nucleation layer is disposed on the substrate 41. For example, the nucleation layer is disposed on a surface of the substrate 41.

The nucleation layer may be formed by using, for example, a metal-organic chemical vapor deposition (metal-organic chemical vapor deposition, MOCVD) method or a molecular beam epitaxy (molecular beam epitaxy, MBE) method.

A material of the nucleation layer may include, for example, one or more of GaN (gallium nitride), AlGaN (aluminum gallium nitride), and AlN (aluminum nitride).

The nucleation layer is to improve an epitaxial quality and to facilitate growth of upper epitaxy.

S12: Form the gradient buffer layer on the nucleation layer.

Alternatively, it is understood as that the gradient buffer layer is formed on a side that is of the nucleation layer and that is away from the substrate 41.

In other words, as shown in FIG. 5A, the gradient buffer layer is disposed on the side that is of the nucleation layer and that is away from the substrate 41. For example, the gradient buffer layer is disposed on a surface that is of the nucleation layer and that is away from the substrate 41.

The gradient buffer layer may be formed by using, for example, an MOCVD process to epitaxially grow an AlGaN gradient layer whose Al (aluminum) composition gradually decreases.

For example, an Al_{0.8}Ga_{0.2}N layer, an Al_{0.5}Ga_{0.5}N layer, and an Al_{0.2}Ga_{0.5}N layer are sequentially formed on the side that is of the nucleation layer and that is away from the substrate 41 by using an MOCVD process, to form the gradient buffer layer.

To reduce a decrease in mobility caused by electron scattering, the gradient buffer layer usually uses a non-doped structure.

A function of the gradient buffer layer is as follows. Band gaps of the gradient buffer layer and the channel layer 42 are different, so that a potential well depth of the heterojunction formed by the barrier layer 43 and the channel layer 42 is deeper. This increases a limitation of the two-dimensional electron gas. In addition, the buffer layer is usually thick, and is a main structure of a device to bear a voltage.

S13: Form the channel layer 42 on the gradient buffer layer.

Alternatively, it is understood as that the channel layer 42 is formed on a side that is of the gradient buffer layer and that is away from the substrate 41.

It can be learned from the foregoing descriptions that both the nucleation layer and the gradient buffer layer are formed on the substrate 41. Therefore, the channel layer 42 formed on the side that is of the gradient buffer layer and that is away from the substrate 41 is also located on the substrate 41.

The channel layer 42 may be formed by using, for example, an MOCVD method or an MBE method.

A material of the channel layer 42 may include, for example, one or more of GaN, AlGaN, InAlN (indium aluminum nitride), A1N, and ScAlN (scandium aluminum nitride).

In some embodiments, a thickness of the channel layer 42 is within a range of 100 nm to 5000 nm. For example, the thickness of the channel layer 42 is 500 nm, 1000 nm, 1500 nm, 2000 nm, 2500 nm, 3000 nm, 3500 nm, 4000 nm, or 4500 nm.

S14: Form the insertion layer on the channel layer 42.

Alternatively, it is understood as that the insertion layer is formed on a side that is of the channel layer 42 and that is away from the substrate 41. In other words, as shown in FIG. 5A, the insertion layer is disposed on the side that is of the channel layer 42 and that is away from the substrate 41. For example, the insertion layer is disposed on a surface that is of the channel layer 42 and that is away from the substrate 41, to improve mobility of the two-dimensional electron gas 44.

The insertion layer may be formed by using, for example, an MOCVD method or an MBE method.

S15: Form the barrier layer 43 on the insertion layer.

Alternatively, it is understood as that the barrier layer 43 is formed on a side that is of the insertion layer and that is away from the substrate 41. In other words, as shown in FIG. 5A, the barrier layer 43 is disposed on the side that is of the insertion layer and that is away from the substrate 41. For example, the barrier layer 43 is disposed on a surface that is of the insertion layer and that is away from the substrate 41.

The barrier layer 43 may be formed by using, for example, an MOCVD method or an MBE method.

A material of the barrier layer 43 may include, for example, one or more of GaN, AlGaN, InAlN, AIN, and ScAlN.

Materials of the channel layer 42 and the barrier layer 43 are different, and the channel layer 42 and the barrier layer 43 form a heterostructure. For example, the material of the channel layer 42 includes GaN, and the material of the barrier layer 43 includes AlGaN.

In some embodiments, a thickness of the barrier layer 43 is within a range of 2 nm to 50 nm. For example, the barrier layer 43 is made of AlGaN that is with a thickness of 25 nm and that includes 25% aluminum composition. For example, the thickness of the barrier layer 43 is 10 nm, 15 nm, 20 nm, 25 nm, 30 nm, 35 nm, 40 nm, or 45 nm.

The barrier layer 43 is usually not doped. A barrier layer having a unidirectional through-current capability is formed below the gate by using a work function difference between the barrier layer 43 and a subsequently formed gate (usually made of a metal material). This ensures a capability of the gate to control the channel layer 42, while an electric leakage problem of the gate can further be effectively reduced.

S16: Form the cap layer on the barrier layer 43.

Alternatively, it is understood as that the cap layer is formed on a side that is of the barrier layer 43 and that is away from the substrate 41. As shown in FIG. 5A, the cap layer is disposed on the side that is of the barrier layer 43 and that is away from the substrate 41. For example, the cap layer is disposed on a surface that is of the barrier layer 43 and that is away from the substrate 41.

The cap layer may be formed by using, for example, an MOCVD method or an MBE method.

A material of the cap layer may be, for example, GaN or Si₃N₄ (silicon nitride). It may be understood that the cap layer should not affect an ohmic contact between the source and the drain and the barrier layer 43. The foregoing effect may be achieved by doping or patterning the cap layer (exposing the barrier layer 43).

A thickness of the cap layer is too small to protect the barrier layer 43. If the cap layer is too thick, a thickness of the HEMT device may be increased. Therefore, in some embodiments, the thickness of the cap layer may be, for example, within a range of 1 nm to 20 nm. For example, the thickness of the cap layer is 5 nm, 10 nm, or 15 nm.

That is, as shown in FIG. 5A, the stacked semiconductor layer on the substrate 41 includes the nucleation layer, the gradient buffer layer, the channel layer 41, the insertion layer, the barrier layer 43, and the cap layer that are disposed in a stacked manner.

However, in this embodiment of this application, when the stacked semiconductor layer is formed, not all of the foregoing steps S11 to S16 are required to be performed. Some of the steps may be performed. Alternatively, another step may be added, provided that at least the heterostructure including the channel layer 42 and the barrier layer 43 is formed on the substrate 41.

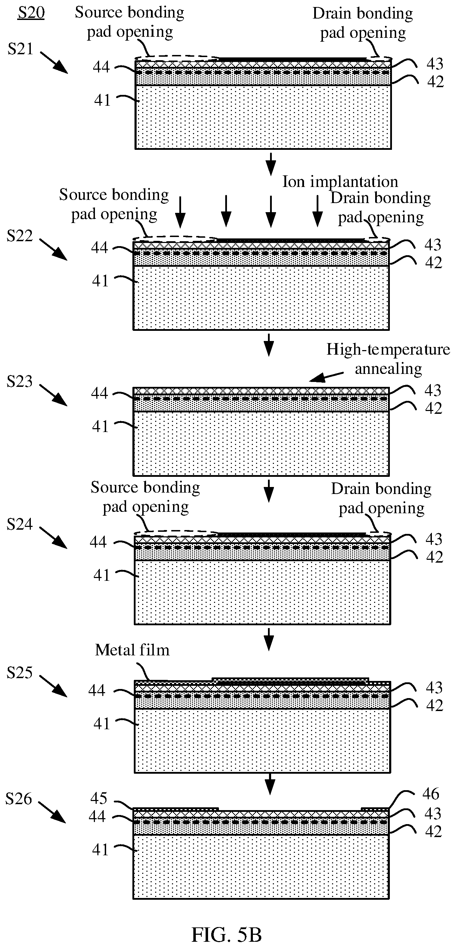

For ease of description, as shown in FIG. 5B, in a subsequent process, only an example in which the stacked semiconductor layer formed on the substrate 41 includes the channel layer 42 and the barrier layer 43 is used for illustration.

S20: As shown in FIG. 5B, form a source 45 and a drain 46 on the stacked semiconductor layer.

For example, in the stacked semiconductor layer, if the cap layer is located at the topmost layer, the source 45 and the drain 46 are formed on the cap layer. Alternatively, for example, in the stacked semiconductor layer, if the barrier layer 43 is located at the topmost layer, the source 45 and the drain 46 are formed on the barrier layer 43. Regardless of which structure is used, it only needs to be ensured that the source 45 and the drain 46 form an ohmic contact with the barrier layer 43.

FIG. 5B shows a manner for forming the source 45 and the drain 46, and S20 includes the following steps.

S21: Produce a photoresist covering the stacked semiconductor layer, and perform photoetching to form a source bonding pad opening in a region in which the source 45 is to be formed, and form a drain bonding pad opening in a region in which the drain 46 is to be formed.

For example, refer to FIG. 5B. The photoresist may be first coated on the stacked semiconductor layer, and a light-shielding plate (photomask mask) is configured to shield the photoresist. A shape of the light-shielding plate is shown in FIG. 5B. A region in which an electrode (for example, the source and the drain) is to be formed is set as a light-transmission region, and a remaining region is a non-light-transmission area. Then, after the coated photoresist is cured, a photoresist in the light-transmission region is activated by irradiating the light-shielding plate by using light, and a photoresist in the light-transmission region is removed, to form the source bonding pad opening and the drain bonding pad opening.

It should be noted that all the photoresists mentioned in the specific implementations of embodiments of this application are positive photoresists. That is, the photoresist may be activated after irradiation, and then the activated photoresist is removed. Certainly, a negative photoresist may alternatively be used in a practical operation. It should be noted that the negative photoresist is not activated after irradiation, and is activated when there is no irradiation. Therefore, when the negative photoresist is used, the light-transmission region and the non-light-transmission region of the light-shielding plate in the figure need to be interchanged. To be specific, the original light-transmission region becomes the non-light-transmission region, the original non-light-transmission region becomes the light-transmission region, and other steps are not changed. Both the methods using the positive photoresist and the negative photoresist shall fall within the protection scope of embodiments of this application.

S22: Inject a donor impurity through the source bonding pad opening and the drain bonding pad opening, and form a doping region after activation.

The donor impurity may be injected through a source bonding pad opening and a drain bonding pad opening by using an ion implantation process. The donor impurity may be, for example, a silicon ion, and the donor impurity may be a single element or a mixture of a plurality of elements. The injection of the donor impurity may reduce a resistivity of an ohmic contact resistance between the source 45 and the drain 46 and the barrier layer 43, and may further reduce a resistivity of the barrier layer 43.

S23: Remove the photoresist, and activate a carrier of the donor impurity by using an annealing process, to form an N-type doping region.

Certainly, the carrier of the injected donor impurity may alternatively be activated by using an annealing process in other subsequent film layer manufacturing.

S24: Then, produce a photoresist covering the stacked semiconductor layer, and perform photoetching to form a source bonding pad opening in a region in which the source 45 is to be formed, and form a drain bonding pad opening in a region in which the drain 46 is to be formed.

S25: Form a metal film covering the photoresist, where the metal film fills the source bonding pad opening and the drain bonding pad opening.

For example, the metal film may be manufactured by using a metal deposition process, a sputtering process, an evaporation process, or an electroplating process.

S26: Remove the photoresist, and retain the source 45 located in the source bonding pad opening, and the drain 46 located in the drain bonding pad opening.

Materials of the source 45 and the drain 46 may be a simple substance, or may be an alloy or a multilayer laminated metal.

In some embodiments, work functions of the materials of the source 45 and the drain 46 are within a range of 4.3 eV to 6 eV.

For example, the materials of the source 45 and the drain 46 include at least one of the following elements: titanium (Ti, a work function is 4.33 eV), gold (Au, a work function is 5.1 eV), and platinum (Pt, a work function is 5.65 eV). For example, the materials of the source 45 and the drain 46 include titanium nitride.

In some embodiments, the materials of the source 45 and the drain 46 do not include an aluminum (Al) element.

In some embodiments, the source 45 and the drain 46 include at least one conductive layer.

For example, the source 45 and the drain 46 include a conductive layer, and a material of the conductive layer may include elements such as titanium, gold, and platinum. The source 45 and the drain 46 are of a single-layer structure, a manufacturing process is simple, and production efficiency is high.

Alternatively, for example, the source 45 and the drain 46 include a plurality of conductive layers, and a material of each conductive layer may be the same or may be different.

The source 45 and the drain 46 include the plurality of conductive layers, and characteristics of different materials may be fused together, so that stresses and resistivities of the source 45 and the drain 46 are adjustable. The source 45 and the drain 46 may further be enabled to include a conductive layer that functions to block, to block diffusion between a plurality of layers of metal. This avoids damage to the HEMT device caused by volume expansion of the source 45 and the drain 46.

In some embodiments, in a case in which the source 45 and the drain 46 include one conductive layer, the material of the conductive layer may include, for example, a titanium element.

In a case in which the source 45 and the drain 46 include the plurality of conductive layers, the source 45 is used as an example. For example, the source 45 includes a first conductive layer and a second conductive layer that are sequentially stacked. The first conductive layer includes a titanium element, the second conductive layer includes a gold element, and the first conductive layer is in contact with and connected to the barrier layer 43.

The titanium element is disposed on a surface of the stacked semiconductor layer (for example, the barrier layer 43). A conductive function is performed while an adhesive function may be further performed. This improves effect of a connection of the source 45 and the drain 46 to the stacked semiconductor layer.

After the stresses and the resistivities of the source 45 and the drain 46 are comprehensively considered, in some embodiments, a thickness of each conductive layer of the source 45 and the drain 46 is within a range of 1 nm to 10000 nm. For example, the thickness of the conductive layer is 100 nm, 500 nm, 1000 nm, 1500 nm, 2000 nm, 2500 nm, 3000 nm, 3500 nm, 4000 nm, 4500 nm, 5000 nm, 6000 nm, 7000 nm, 8000 nm, or 9000 nm.

Certainly, thicknesses of the conductive layers may be equal or may be unequal. This is not limited in this embodiment of this application, and may be properly set as required.

The thickness of each conductive layer is properly set, so that resistances of the source 45 and the drain 46 can be reduced without a need to dispose an auxiliary electrode. A structure is simple, process steps are few, and manufacturing efficiency is high.

As shown in FIG. 5B, the source 45 and the drain 46 are disposed on the surface of the stacked semiconductor layer (for example, the barrier layer 43), and the source 45 is a conductive structure closest to the stacked semiconductor layer (for example, the barrier layer 43).

Alternatively, it is understood as that the source 45 and the drain 46 are a first layer of conductive structures disposed on the stacked semiconductor layer (for example, the barrier layer 43), and no other conductive structure is disposed between the source 45 and the drain 46.

In some embodiments, as shown in FIG. 5B, the source 45 is of a planar structure.

Alternatively, it is understood as that no structure such as an opening or a hollow-out pattern is disposed on the source 45.

The source 45 is of the planar structure, so that a structure is simple and the manufacturing process is simple. In addition, there is no need to consider a problem of how a plurality of strip structures are interconnected after an opening is disposed on the source 45 and the source 45 is divided into structures including a plurality of strip patterns.

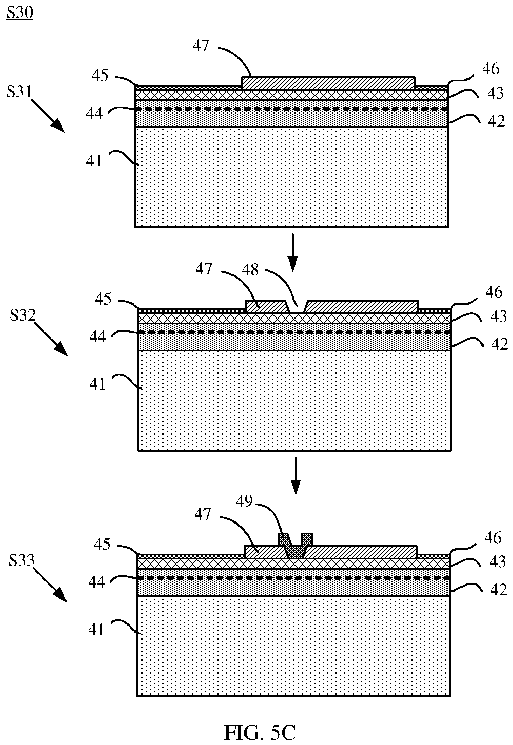

S30: As shown in FIG. 5C, form a gate 49 located between the source 45 and the drain 46.

A material of the gate 49 may be, for example, a metal with a high work function. For example, the material of the gate 49 may be nickel (Ni, a work function is 4.6 eV), gold, and the like. The gate 49 is disposed on the barrier layer 43, and forms a Schottky contact with the barrier layer 43.

In some embodiments, as shown in FIG. 5C, step S30 includes the following steps.

S31: Form a first dielectric layer 47 on the source 45 and the drain 46.

A material of the first dielectric layer 47 may be, for example, an insulation dielectric such as silicon nitride, silicon oxide, or aluminum oxide. A thickness of the first dielectric layer 47 may be within a range of 10 nm to 200 nm. For example, the thickness of the first dielectric layer 47 is 50 nm, 100 nm, or 150 nm.

For example, the first dielectric layer 47 may be formed by using a process such as plasma chemical vapor deposition, atomic layer deposition, or low-pressure chemical vapor deposition.

It should be noted that, the first dielectric layer 47 formed in step S31, as shown in FIG. 5C, may expose the source 45 and the drain 46. The first dielectric layer 47 formed in step S31 may alternatively cover the source 45 and the drain 46. Patterning is then performed in another subsequent step to expose the source 45 and the drain 46.

S32: Form a gate bonding pad opening 48 on the first dielectric layer 47.

A manner for forming the gate bonding pad opening 48 is as follows. For example, a photoresist may be formed on the first dielectric layer 47 as a mask to expose the gate bonding pad opening 48. An etching process (dry etching or wet etching) is used to form the gate bonding pad opening 48. The photoresist is removed.

In a case in which the first dielectric layer 47 exposes the source 45 and the drain 46, the process of forming the gate bonding pad opening 48 on the first dielectric layer 47 may be completed simultaneously as the process of exposing the source 45 and the drain 46 on the first dielectric layer 47. Alternatively, the two processes may be completed in several times.

A size of the gate bonding pad opening 48 limits a size of the gate 49 to be formed. In some embodiments, the gate bonding pad opening 48 is a groove. A width of the groove is within a range of 10 nm to 1000 nm. For example, the width of the groove is 100 nm, 200 nm, 300 nm, 400 nm, 500 nm, 600 nm, 700 nm, 800 nm, or 900 nm.

S33: Form the gate 49.

The process of forming the gate 49, for example, may be the same as the processes of forming the source 45 and the drain 46. Refer to the foregoing descriptions. The gate bonding pad opening 48 on the first dielectric layer 47 is located between the source 45 and the drain 46, and the finally formed gate 49 is also located between the source 45 and the drain 46.

It should be noted that, in this embodiment of this application, as shown in the foregoing steps, the source 45 and the drain 46 may be first formed simultaneously, and then the gate 49 is formed. Alternatively, the gate 49 may be first formed, and then the source 45 and the drain 46 are formed simultaneously. Alternatively, the source 45, the drain 46, and the gate 49 may be formed simultaneously.

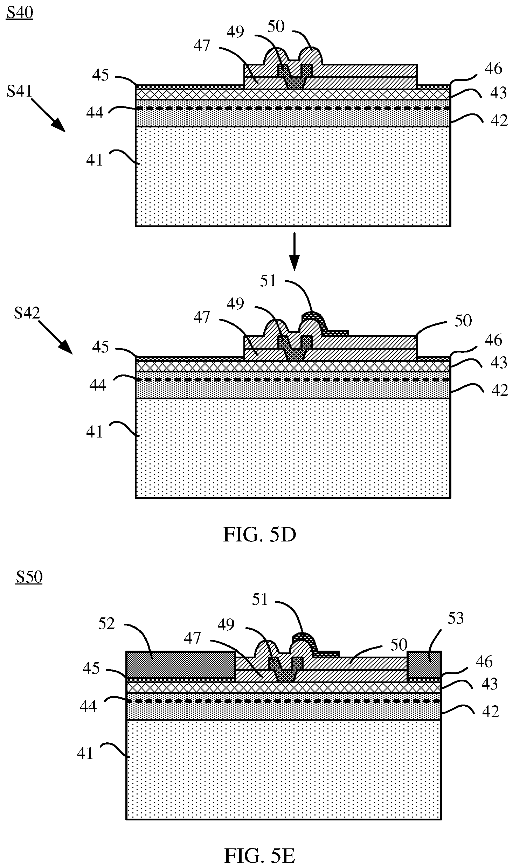

S40: As shown in FIG. 5D, form a field plate (field plate, FP) 51.

A material of the field plate 51 may be any conductive material. The field plate 51 is disposed on a side that is of the gate 49 and that is away from the substrate 41, and is located above a region between the gate 49 and the drain 46. An orthographic projection of the field plate 51 on the substrate 41 overlaps an orthographic projection of the gate 49 on the substrate 41.

In some embodiments, as shown in FIG. 5D, step S40 includes the following steps.

S41: Form a second dielectric layer 50.

A material of the second dielectric layer 50 may be, for example, an insulation dielectric such as silicon nitride, silicon oxide, or aluminum oxide. A thickness of the second dielectric layer 50 may be within a range of 50 nm to 1000 nm. For example, the thickness of the second dielectric layer 50 is 100 nm, 200 nm, 300 nm, 400 nm, 500 nm, 600 nm, 700 nm, 800 nm, or 900 nm.

For example, the second dielectric layer 50 may be formed by using a process such as plasma chemical vapor deposition, atomic layer deposition, or low-pressure chemical vapor deposition.

It should be noted that, the second dielectric layer 50 formed in step S41, as shown in FIG. 5D, may expose the source 45 and the drain 46. The second dielectric layer 50 formed in step S41 may alternatively cover the source 45 and the drain 46. Patterning is then performed in another subsequent step to expose the source 45 and the drain 46.

S42: Form the field plate 51.

The method for forming the field plate 51 may be the same as the methods for forming the source 45 and the drain 46. Refer to the foregoing descriptions.

The field plate 51 may be in a floating state, and does not load any signal. The field plate 51 may alternatively be in contact with the source 45, and the field plate 51 may further be in contact with the gate 49.

An electric field peak is likely to occur at a position of the gate 49. Therefore, the field plate 51 is disposed above the gate 49, so that electric field distribution in the HEMT device may be modulated. This enables the electric field distribution to be even, and the electric field peak is avoided.

S50: As shown in FIG. 5E, form a thickened source 52 and a thickened drain 53.

The thickened source 52 is disposed on the source 45, and is in contact with and connected to the source 45. The thickened drain 53 is disposed on the drain 46, and is in contact with and connected to the drain 46.

Materials of the thickened source 52 and the thickened drain 53 are not limited, and may be the same as or different from the materials of the source 45 and the drain 46. Manners for manufacturing the thickened source 52 and the thickened drain 53 may also be the same as the manners for manufacturing the source 45 and the drain 46. Refer to the foregoing related descriptions.

Thicknesses of the thickened source 52 and the thickened drain 53 may be, for example, within a range of 500 nm to 10000 nm. For example, thicknesses of the thickened source 52 and the thickened drain 53 are 1000 nm, 2000 nm, 3000 nm, 4000 nm, 5000 nm, 6000 nm, 7000 nm, 8000 nm, or 9000 nm.

The thickened source 52 and the thickened drain 53 are disposed, and it is equivalent to increasing the thicknesses of the source 45 and the drain 46 and reducing the resistance of the source 45 and the drain 46, so that a current conduction capability of the semiconductor device is improved. However, it should be noted that, sizes of the thickened source 52 and the thickened drain 53 are not required to be the same as sizes of the source 45 and the drain 46, and may be larger than or smaller than sizes of the source 45 and the drain 46, all of which can improve a current conduction capability.

S60: Deposit a peripheral passivation layer or a waterproof layer on the device.

To be specific, the passivation layer (including a dielectric material) or the waterproof layer (including a waterproof material) is wrapped around a periphery of the device to protect the device.

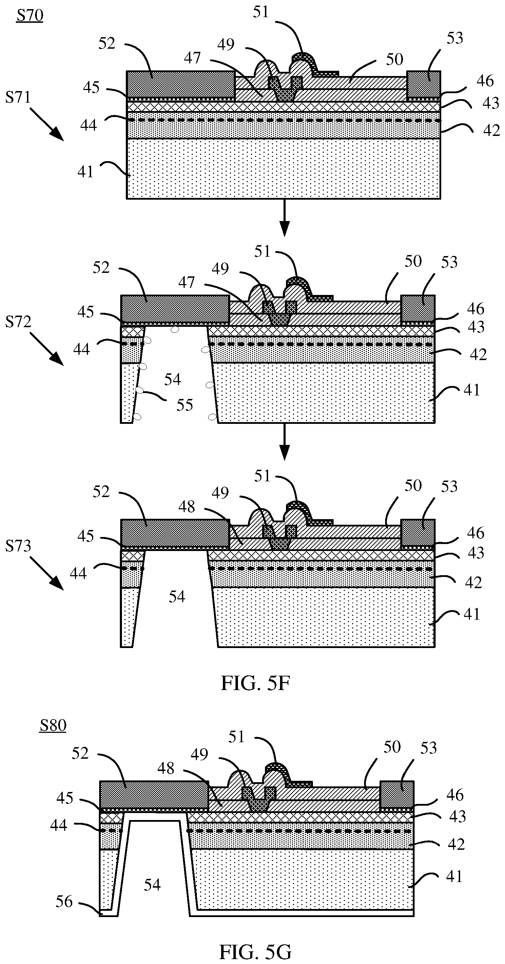

S70: As shown in FIG. 5F, form a backside via 54 below the source 45.

The backside via 54 runs through a region from the substrate 41 to the barrier layer 43 below the source 45. Alternatively, it is understood as that the backside via 54 runs through, from a back surface that is of the substrate 41 and that is away from the channel layer 42, to a surface that is of the source 45 and that is close to the substrate 41. In other words, the backside via 54 runs through the stacked semiconductor layer on the substrate 41 to reach the surface that is of the source 45 and that is close to the substrate 41.

In some embodiments, as shown in FIG. 5F, step S70 includes the following steps.

S71: Thin a back surface of the substrate 41.

After a process of a front surface of the substrate 41 is completed, a process of the back surface of the substrate 41 needs to be performed, to implement a connection to the back surface from the source 45 through the device. After the process of a front surface of the substrate 41 is completed, a requirement for a bearing capacity of the substrate 41 is reduced. Therefore, before the backside via 54 is formed on the substrate 41, the substrate 41 may be thinned first. Forming difficulty of the backside via 54 may be reduced. In addition, the thickness of the finally formed semiconductor device may be reduced.

In some embodiments, a thickness of the substrate 41 after being thinned is within a range of 10 um to 500 um. For example, the thickness of the substrate 41 after being thinned is 100 um, 200 um, 300 um, or 400 um.

S72: Make, from the back surface of the substrate 41, a via on a film layer that is of the source 45 and that is close to a side of the substrate 41, to form the backside via 54.

The film layer that is of the source 45 and that is close to a side of the substrate 41 may be the substrate 41 and the stacked semiconductor layer that is disposed on the substrate 41.

For example, a photoresist is first coated on the back surface of the substrate 41. The photoresist is exposed by using a mask plate. The photoresist is developed, and the photoresist is used as a mask to expose a region of the backside via 54 to be formed. A dry etching process or a wet etching process is used to make the via on the film layer that is of the source 45 and that is close to a side of the substrate 41 to form the backside via 54. The photoresist is removed.

Certainly, another mask layer such as a metal layer mask layer or a dielectric mask layer may be used as a hole mask. In addition, when the stacked semiconductor layer on the substrate 41 is etched, the substrate 41 may be used as a mask.

A width of the backside via 54 may be set to be large, and may even be equal to a width of the source 45, to reduce manufacturing difficulty of the backside via 54 and a subsequent back metal layer. A size of the backside via 54 is not limited in this embodiment of this application, and may be properly selected after a factor such as a process is comprehensively considered.

S73: Remove an etching by-product 55 that remains in the backside via 54 through dry etching or wet etching.

The photoresist may be removed in step S72, or may be removed after step S73.

An etching solution of wet etching may include, for example, a solution such as hydrochloric acid, nitrate, potassium hydroxide (KOH), or tetramethyl ammonium hydroxide (TMAH).

S80: As shown in FIG. 5G, form a backside conductive layer 56 on the back surface of the substrate 41, where the backside conductive layer 56 is in contact with and connected to the source 45 through the backside via 54.

As shown in FIG. 5G, the backside conductive layer 56 covers a surface of the backside via 54 and the back surface of the substrate 41. The source 45 is directly in contact with and connected to the backside conductive layer 56.

A material of the backside conductive layer 56 may include, for example, gold and titanium gold. A thickness of the backside conductive layer 56 may be, for example, within a range of 500 nm to 30000 nm. The backside conductive layer 56 may be manufactured by using, for example, an electroplating process, an evaporation process, or a sputtering process.

It should be noted that the manufacturing method for the semiconductor device provided in this embodiment of this application is not limited to the foregoing steps, and another step may be added or some of the foregoing steps may be removed as required. In addition, a sequence of steps in the foregoing manufacturing method is merely an example, and may be adjusted and interchanged as required.

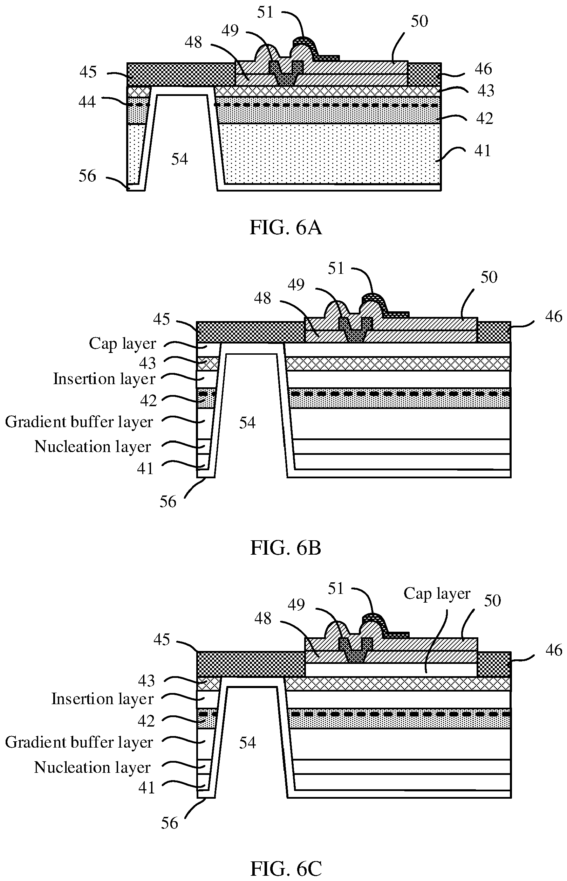

As shown in FIG. 6A, the semiconductor device obtained through manufacturing by using the foregoing manufacturing methods includes: the substrate 41; and the channel layer 42 and the barrier layer 43 that are sequentially disposed on the substrate 41 in a stacked manner, where the channel layer 42 and the barrier layer 43 form the heterojunction, and the two-dimensional electron gas 44 is generated in the channel layer 43. The source 45 and the drain 46 are disposed on a surface of the barrier layer 43, and form an ohmic contact with the barrier layer 43. The source 45 is of the planar structure, and the source 45 is the conductive structure closest to the barrier layer 43. The gate 49 is disposed on the barrier layer 43, and is located between the source 45 and the drain 46. The field plate 51 is disposed on the side that is of the gate 49 and that is away from the substrate 41, is located between the gate 49 and the drain 46, and overlaps a projection of the gate 49.

The backside via 54 is located below the source 45, and the backside via 45 runs through, from the back surface that is of the substrate 41 and that is away from the channel layer 42, to the surface that is of the source 45 and that is close to the substrate 41. The backside conductive layer 56 is disposed on the back surface of the substrate 41, and is in contact with and connected to the source 45 through the backside via 54.

In some embodiments, as shown in FIG. 5G, the semiconductor device further includes the thickened source 52 and the thickened drain 53. The thickened source 52 is disposed on the source 45, and is in contact with and connected to the source 45. The thickened drain 53 is disposed on the drain 46, and is in contact with and connected to the drain 46.

In some embodiments, as shown in FIG. 6B, the semiconductor device further includes the nucleation layer and the gradient buffer layer that are sequentially disposed between the substrate 41 and the channel layer 42 in a stacked manner, the insertion layer disposed between the channel layer 41 and the barrier layer 43, and the cap layer disposed on the surface of the barrier layer 43.

Based on different materials of the cap layer, for example, as shown in FIG. 6B, the cap layer is disposed between the source 45 and the drain 46 and the barrier layer 43.

Alternatively, for example, as shown in FIG. 6C, the opening that exposes the source 45 and the drain 46 is disposed on the cap layer, and the source 45 and the drain 46 are directly in contact with the barrier layer 43.

A working principle of the HEMT device is as follows. The source 45 and the drain 46 separately form a conductive ohmic contact with the barrier layer 43, and the gate 49 forms a Schottky contact with the barrier layer 43. A dashed line in the channel layer 42 represents the 2DEG 44 generated by polarization in the heterojunction formed by the channel layer 42 and the barrier layer 43 in the HEMT device. The 2DEG 44 is used to efficiently conduct an electron under an action of an electric field. The source 45 and the drain 46 are configured to enable the 2DEG 44 to flow in the channel layer 42 between the source 45 and the drain 46 under an action of the electric field, and conduction between the source 45 and the drain 46 occurs at the 2DEG 44 in the channel layer 42. The gate 49 is disposed between the source 45 and the drain 46, and is configured to allow or block passing of the 2DEG 44, to control the conduction and cutoff of the HEMT device.

It should be noted that, based on any one of the foregoing HEMT devices, after the HEMT device is used in the integrated circuit 31, in some embodiments, backside conductive layers 56 of the plurality of HEMT devices included in the integrated circuit 31 are in contact with and connected to each other. Alternatively, in some embodiments, in the plurality of HEMT devices included in the integrated circuit 31, backside conductive layers 56 of some HEMT devices are in contact with and connected to each other. Alternatively, in some embodiments, in the plurality of HEMT devices included in the integrated circuit 31, the backside conductive layers 56 of the HEMT devices are independent of each other.

In this embodiment of this application, the source 45 is directly in ohmic contact with the barrier layer 43, and the backside via 54 is located below the source 45. In this way, the backside via 54 is disposed below the source 45, and the backside conductive layer 56 is directly in contact with and connected to the source 45 through the backside via 54. A signal is directly conducted from the source 45 to the backside conductive layer 56, so that a transmission path to the source 45 is shortened. This can reduce an inductance of the semiconductor device, and increase a frequency of the semiconductor device. In addition, the width of the backside via 54 may be set properly as required, and the width of the backside via 54 does not need to be additionally reduced, to reduce manufacturing process difficulty and a yield rate of the backside via 54, and improve a yield rate and reliability of the backside conductive layer 56, so that a yield rate and reliability of the semiconductor device are improved. Therefore, the size of the device source 45 is reduced, so that a small-sized and low-cost semiconductor device can be obtained through manufacturing.

Optionally, in the process of manufacturing the semiconductor device, the material of the source 45 is selected as a metal (for example, titanium, gold, and platinum) with a high work function and a stable chemical property, and no longer includes a reactive metal such as aluminum. The source 45 is enabled to block etching of the backside via, and corrosion in backside via process wet processing can be avoided.

Optionally, an alloy may be used or a process may be improved, so that the source 45 may not be corroded due to etching in a manufacturing process of the backside via 54.

As a result, even if the source 45 is touched during the backside via process, no damage is caused to the source 45. Therefore, there is no need to specifically dispose the source 45 apart from the backside via 54 to avoid the corrosion caused by the backside via process. This reduces the size of the source 45 and reduces the size of the entire semiconductor device.

### Example 2

A difference between Example 2 and Example 1 lies in that the source 45 has an opening.

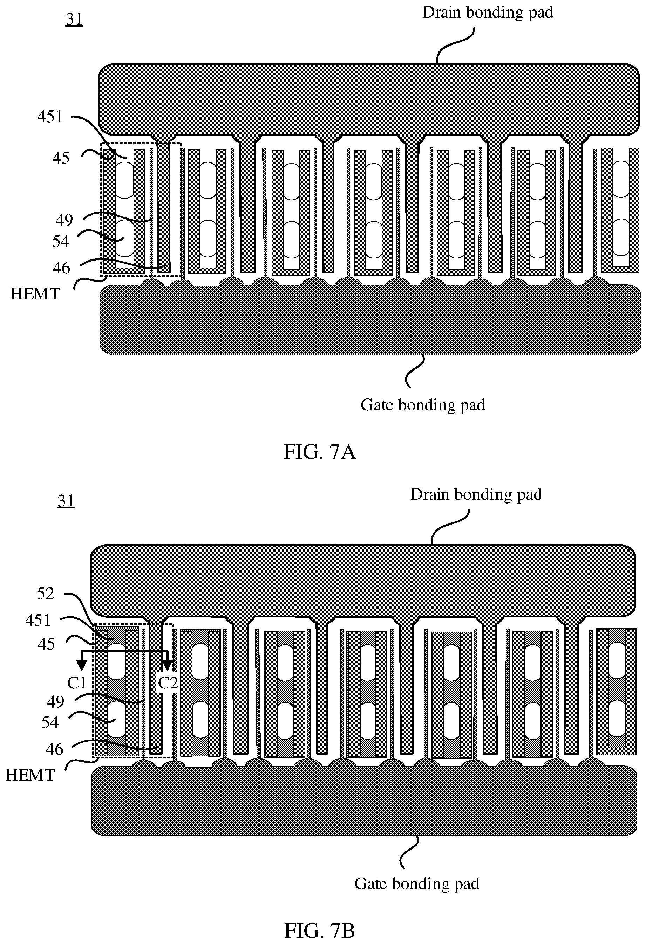

As shown in FIG. 7A, the source 45 in the semiconductor device is no longer of the planar structure, but has an opening 451, and the opening 451 is located above the backside via 54.

A shape of the opening 451 is not limited, and the shape of the opening 451 in FIG. 7A is merely an example.

It may be understood that the source 45 has the opening 451, but disposing of the opening 451 should not affect a signal transmission on the source 45.

In some embodiments, as shown in FIG. 7A, the source 45 has the opening 451, but the source 45 is still a structure that is interconnected everywhere.

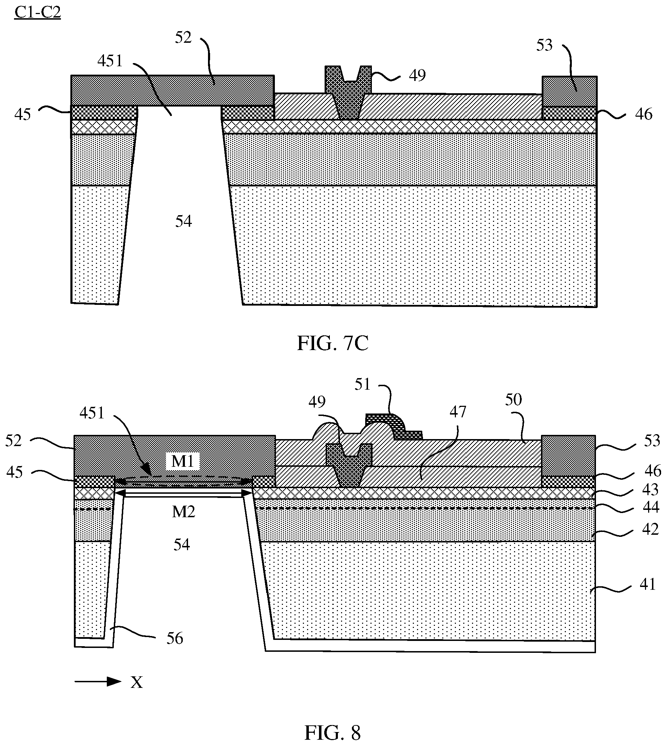

In some other embodiments, as shown in FIG. 7B, the opening 451 on the source 45 divides the source 45 into a plurality of strip structures. As shown in FIG. 7C (a sectional view along a direction C1-C2 of FIG. 7B), the strip structures may be interconnected by using, for example, the thickened source 52. To be specific, each part of the source 45 is in contact with and connected to the thickened source 52, to implement interconnection among all parts of the source 45.

In other words, as shown in FIG. 8, in some embodiments, the semiconductor device further includes the thickened source 52 and the thickened drain 53. The thickened source 52 is in contact with and connected to the backside conductive layer 56 through the opening 451 on the source 45.

For a structure relationship between the opening 451 and the backside via 54, in some embodiments, a width M1 of the opening 451 is less than or equal to a width M2 of the backside via 54.

Compared with that the width M1 of the opening 451 needs to be greater than the width M2 of the backside via 54, that the width M1 of the opening 451 is less than or equal to the width M2 of the backside via 54 is equivalent to reducing the width M1 of the opening 451, so that the width of the source 45 can be reduced.

Based on a structure relationship between the source 45 and the backside conductive layer 56 that is brought by the structure relationship between the opening 451 and the backside via 54, in some embodiments, the backside conductive layer 56 is close to a left side of the gate 49 and away from a right side of the gate 49, and the left side and/or the right side of the backside conductive layer 56 are/is in contact with and connected to the source 45.

In some embodiments, as shown in FIG. 8, the left side and the right side of the backside conductive layer 56 are exactly in critical contact with the source 45.

In other words, there is no gap between the left side and the right side of the opening 451 and the backside via 54.

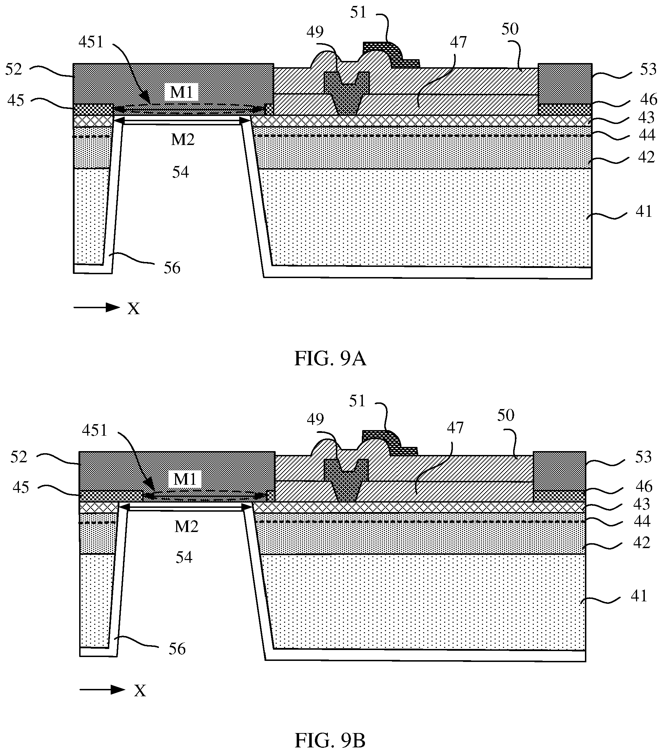

In some other embodiments, as shown in FIG. 9A, the left side of the backside conductive layer 56 is exactly in critical contact with the source 45, and there is a gap between the right side of the backside conductive layer 56 and the source 45.

In other words, there is no gap between the left side of the opening 451 and the backside via 54, and there is a gap between the right side of the opening 451 and the backside via 54.

In some other embodiments, as shown in FIG. 9B, the left side of the backside conductive layer 56 is exactly bonded to the source 45, and there is a gap between the right side of the backside conductive layer 56 and the source 45.

In other words, there is no gap between the left side of the opening 451 and the backside via 54, and there is a gap between the right side of the opening 451 and the backside via 54.

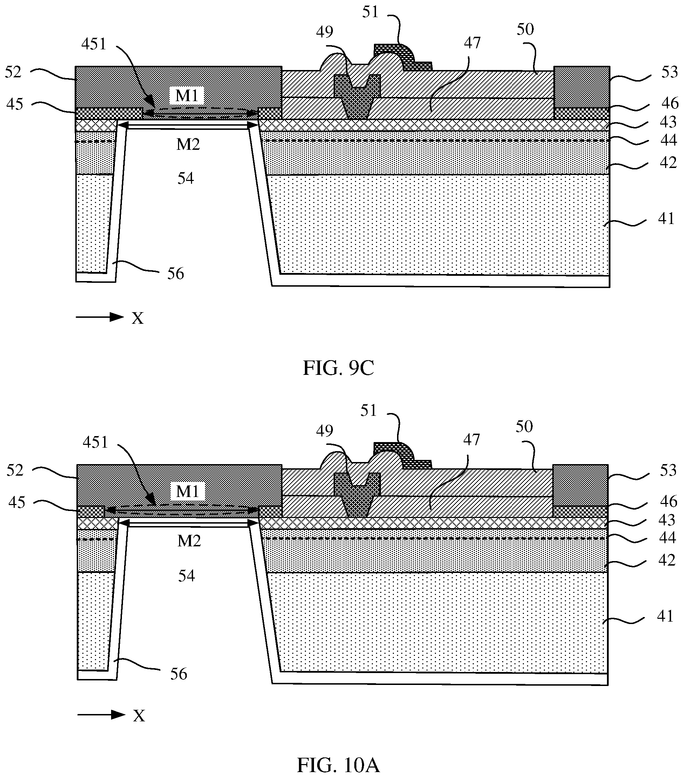

In some other embodiments, as shown in FIG. 9C, the left side of the backside conductive layer 56 is bonded to the source 45, and the right side of the backside conductive layer 56 is exactly in critical contact with the source 45.

In other words, there is no gap between the left side and the right side of the opening 451 and the backside via 54.

In some other embodiments, as shown in FIG. 10A, the right side of the backside conductive layer 56 is exactly in critical contact with the source 45, and there is a gap between the left side of the backside conductive layer 56 and the source 45.

In other words, there is no gap between the right side of the opening 451 and the backside via 54, and there is a gap between the left side of the opening 451 and the backside via 54.

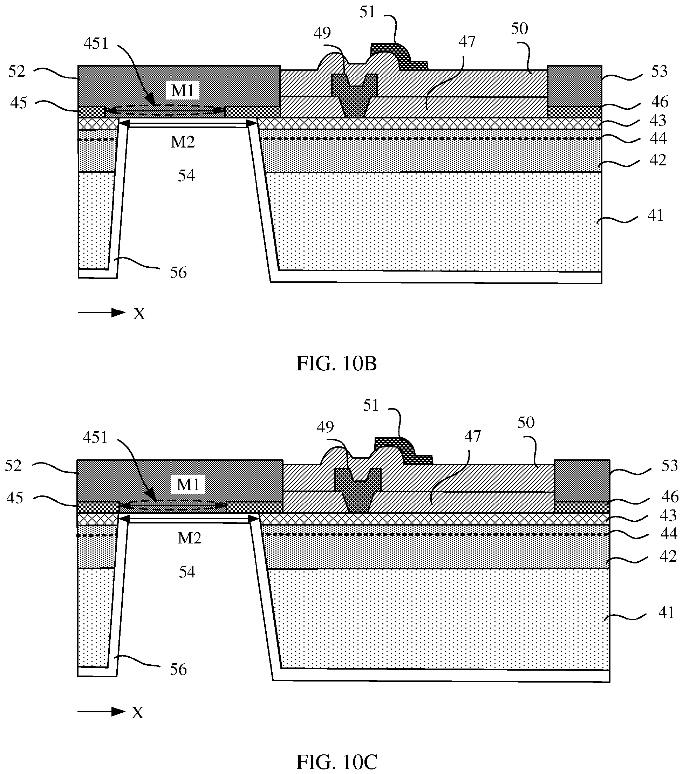

In some other embodiments, as shown in FIG. 10B, the right side of the backside conductive layer 56 is exactly bonded to the source 45, and there is a gap between the left side of the backside conductive layer 56 and the source 45.

In other words, there is no gap between the right side of the opening 451 and the backside via 54, and there is a gap between the left side of the opening 451 and the backside via 54.

In some other embodiments, as shown in FIG. 10C, the right side of the backside conductive layer 56 is bonded to the source 45, and the left side of the backside conductive layer 56 is exactly in critical contact with the source 45.

In other words, there is no gap between the left side and the right side of the opening 451 and the backside via 54.

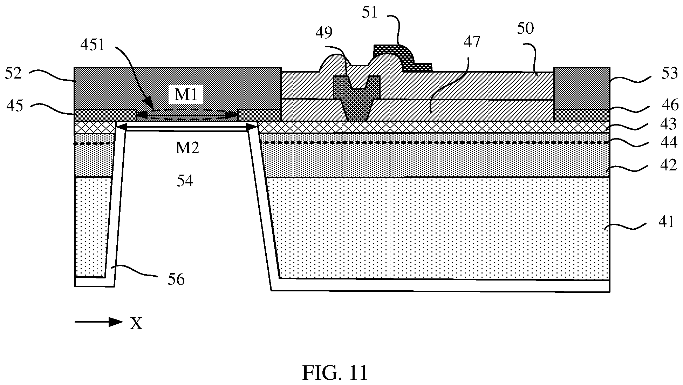

In some other embodiments, as shown in FIG. 11, the right side of the backside conductive layer 56 is bonded to the source 45, and the left side of the backside conductive layer 56 is bonded to the source 45.

In other words, there is no gap between the left side and the right side of the opening 451 and the backside via 54.

In this embodiment of this application, the backside via 54 is disposed below the source 45. Although the opening 451 is disposed on the source 45, the source 45 may not be corroded due to etching in the manufacturing process of the backside via 54. That is, even if the source 45 is touched during the backside via process, no damage is caused to the source 45. Therefore, there is no need to set the opening on the source 45 to be larger than the size of the backside via to avoid corrosion caused by the process of the backside via 54. In other words, the width M1 of the opening 451 is less than or equal to the width M2 of the backside via 54, and there is no gap between the left side and/or the right side of the backside via 54 and the opening 451. That is, the left side and/or the right side of the backside conductive layer 56 are/is in contact with and connected to the source 45. Therefore, the opening 451 is disposed on the source 45 as required. However, the size of the opening 451 may be reduced, so that the size of the source 45 may be reduced, and the size of the semiconductor device may not be increased.

It should be noted that, the foregoing example in which the semiconductor device provided in embodiments of this application is the HEMT device is used, but is not limited to that the semiconductor device is the HEMT device. The semiconductor device provided in embodiments of this application may be any semiconductor device whose source needs to be grounded.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising:
a substrate;
a channel layer and a barrier layer, sequentially disposed on the substrate in a stacked manner;
a source, a gate, and a drain, disposed on the barrier layer;
a backside via, running through a region from the substrate to the barrier layer below the source; and
a backside conductive layer, covering the backside via and a back surface of the substrate, wherein the source is in contact with and connected to the backside conductive layer.

2. The semiconductor device according to claim 1, wherein a work function of a material of the source is within a range of 4.3 eV to 6 eV.

3. The semiconductor device according to claim 1 or 2, wherein the material of the source comprises at least one of elements titanium, gold, and platinum.

4. The semiconductor device according to any one of claims 1 to 3, wherein the source comprises at least one conductive layer.

5. The semiconductor device according to claim 4, wherein the source comprises a first conductive layer and a second conductive layer that are sequentially stacked, the first conductive layer comprises a titanium element, the second conductive layer comprises a gold element, and the first conductive layer is in contact with and connected to the barrier layer.

6. The semiconductor device according to claim 4 or 5, wherein a thickness of each conductive layer is within a range of 1 nm to 10000 nm.

7. The semiconductor device according to any one of claims 1 to 6, wherein the source is of a planar structure.

8. The semiconductor device according to any one of claims 1 to 7, wherein the source has an opening, and the opening is located above the backside via.

9. The semiconductor device according to any one of claims 1 to 8, wherein the semiconductor device further comprises a thickened source; and
the thickened source is disposed on a surface of the source.

10. The semiconductor device according to claim 8, wherein the semiconductor device further comprises a thickened source, the thickened source is disposed on a surface of the source, and the thickened source is in contact with the backside conductive layer through the opening.

11. The semiconductor device according to any one of claims 1 to 10, wherein the semiconductor device further comprises a field plate; and
the field plate is disposed on a side that is of the gate and that is away from the substrate, is located between the gate and the drain, and overlaps a projection of the gate.

12. A power amplification circuit, comprising a package structure and the semiconductor device according to any one of claims 1 to 11, wherein the semiconductor device is packaged inside the package structure.

13. An electronic device, comprising a power amplifier and an antenna, wherein the power amplifier is configured to amplify a radio frequency signal and output the amplified radio frequency signal to the antenna for external radiation, and the power amplifier comprises the power amplification circuit according to claim 12.

14. A manufacturing method for a semiconductor device, comprising:
sequentially forming, on a substrate, a channel layer and a barrier layer that are disposed in a stacked manner;
forming a source, a gate, and a drain on the barrier layer;
forming a backside via below the source, wherein the backside via runs through a region from the substrate to the barrier layer below the source; and
forming a backside conductive layer on a back surface of the substrate, wherein the backside conductive layer covers the backside via and the back surface of the substrate, and the source is in contact with and connected to the backside conductive layer.

15. The manufacturing method of the semiconductor device according to claim 14, wherein the forming a backside via below the source comprises:
making, from the back surface of the substrate, a via on a film layer below the source by using a dry etching process, to form the back side via; and
removing an etching by-product that remains in the via through dry etching or wet etching.
